# EUROPEAN PATENT APPLICATION

(11) **EP 4 443 514 A1**
(43) Date of publication of application: **09.10.2024**
(21) Application number: 23166308.9
(22) Date of filing: 03.04.2023
(51) Int. Cl.: H01L 29/10, H01L 29/66, H01L 29/732, H01L 21/8222, H01L 27/082

(54) **METHODS OF FABRICATING A SI BJT, AND CORRESPONDING DEVICES**

(71) Applicant: NXP B.V., 5656 AG Eindhoven (NL)
(72) Inventor: Huang, Chih Fan, 5656AG Eindhoven (NL); Donkers, Johannes Josephus Theodorus Marinus, 5656AG Eindhoven (NL)
(74) Representative: Hardingham, Christopher Mark

(57) **Abstract**

A method of manufacturing a Si BJT device is disclosed comprising prior processing steps; formation of a protective oxide layer over an active area of the Si BJT device; deposition of a dielectric layer, and a layer stack comprising SiGe, on the protective oxide; etching the dielectric layer, and the layer stack comprising SiGe, thereby removing them from the active area of the Si BJT; deposition of a polysilicon layer, and a further dielectric layer, across the device; etching the polysilicon base, and the further dielectric layer thereby removing it from the active area; implanting, through the protective oxide layer, a p-type dopant into the active area; etching the protective oxide layer, thereby removing it, and leaving voids under the dielectric layer; thermally treating the Si BJT device, thereby filling in voids under the polysilicon base; and subsequent processing steps. Corresponding devices are also disclosed.

## Description

### Field

The present disclosure relates to Silicon Bipolar Junction Transistors and to methods of making the same.

### Background

A Si BJT typically includes a silicon-based emitter layer which is grown directly onto an implanted base region. In some conventional methods it is known to include a protective layer over the implanted base region during prior processing steps in order to protect the base, and to remove this protective layer prior to growing the silicon-based emitter layer. However, such methods typically add complexity to process flows which include other types of device on the same wafer or on the same product within the wafer. It would be useful to provide a method which is directly compatible or more compatible with manufacture of other devices on the same wafer.

### Summary

According to a first aspect of the present disclosure, there is provided a Si bipolar junction transistor device, comprising an n-type collector region grown epitaxially on a silicon substrate; an implanted p-type base region formed in a top region of the collector region; a dielectric layer, and a layer stack comprising SiGe, formed non-adjacent to an emitter window and on a part of the base region; a polysilicon layer, over the dielectric layer, between the dielectric layer and the emitter window and between the layer stack comprising SiGe and the emitter window, the polysilicon layer for providing electrical contact to the base region; dielectric material lining and thereby defining the emitter window; further silicon material within the emitter window and providing an n-emitter base region, and for providing electrical contact to the n-type emitter region; wherein the polysilicon layer comprises non-uniformities adjacent at least a lower part of the dielectric layer.

The non-uniformities adjacent at least a lower part of the dielectric layer are indicative that a protective layer such as a protective TEOS oxide has been used to protect the surface of the epitaxial silicon during device processing. The protective oxide may result in an improved emitter base interface, thereby resulting in improvements in one or more device performance parameters.

In one or more embodiments, the non-uniformities comprise micro-voids. Micro-voids may result from partially filling cavities or voids left by the protective layer.

In one or more embodiments, the non-uniformities comprise silicon material having a different doping level than a remainder of the polysilicon layer. A different doping level adjacent at least the lower part of the dielectric layer may be indicative that silicon from the polysilicon layer has migrated to at least partially fill voids thereat. Since dopant atoms or ions typically migrate at a different rate from silicon atoms and ions a doping non-uniformity may generally result.

In one or more embodiments, the polysilicon layer adjacent the implanted p-type base region is not epitaxial therewith. In conventional Si BJT devices, the polysilicon layer may be deposited directly onto the base layer and may be epitaxial therewith (resulting in part of the polysilicon actually being mono-crystalline). According to embodiments of the present disclosure, the polysilicon layer in this region of the device may have resulted from silicon migration rather than from epitaxial growth.

In one of more embodiments, an upper surface of the implanted p-type base region has a uniform height. In contrast to conventional Si BJTs, the implanted p-type base region is protected by the protective oxide layer, during etching of overlying silicon layers. Over-etching, which may otherwise result in partial etching into the implanted p-type base region resulting in a non-uniform height of its surface, may therefore be prevented or avoided.

According to a further aspect of the present disclosure, there is provided a semiconductor product comprising a Si BJT as described above, and a SiGe heterojunction bipolar transistor, HBT.

According to a second aspect of the present disclosure, there is provided a method of manufacturing a Si bipolar junction transistor (BJT) device, the method comprising prior processing steps; deposition of a protective oxide layer over an active area of the Si BJT device; deposition of a dielectric layer, and a layer stack comprises SiGe, on the protective oxide; etching the dielectric layer, and the layer stack comprising SiGe, thereby removing them from the active area of the Si BJT; deposition of a polysilicon layer, and a further dielectric layer, across the device; etching the polysilicon base, and the further dielectric layer thereby removing it from the active area of the Si BJT; implanting, through the protective oxide layer, an [upper part of] the active area of the Si BJT with a p-type dopant; etching the protective oxide layer, thereby removing it [from the active area of the Si BJT device], and leaving voids under the dielectric layer; thermally treating the Si BJT device, thereby filling in voids under the polysilicon base; and subsequent processing steps. The steps above may be performed in sequence, and there may be additional process steps therebetween.

Providing a protective oxide may protect the surface of the epitaxial silicon during device processing, in particular during the steps of opening a windows in the dielectric and layer stack comprising SiGe (at the position of the emitter window), of implanting p-type dopant such as in into the epitaxial silicon to form the intrinsic base of the BJT, and of etching the dielectric lining material to the emitter window, The protective oxide may result in an improved emitter base interface, thereby resulting in improvements in one or more device performance parameters.

In one or more embodiments, the protective oxide layer is formed from TEOS. Forming the protective oxide from TEOS may be particularly convenient since this material is well-suited use as a protective layer in emitter window.

In one or more embodiments the dielectric layer comprises a nitride material. In one or more embodiments the further dielectric layer comprises a nitride material. In one or more embodiments the p-type dopant is boron. In one or more embodiments, the protective oxide layer has a thickness within a range of 25 nm to 150 nm.

In one or more embodiments, the step of thermally treating the Si BJT device comprises heating it to a temperature such that at least one of atoms or ions of the polysilicon layer migrate into the voids, thereby reducing the size of the voids by at least 75%, within a time which is no more than 10 minutes.

In one or more embodiments, the method further comprises fabricating a SiGe HBT in a same process flow.

These and other aspects of the invention will be apparent from, and elucidated with reference to, the embodiments described hereinafter.

### Brief description of Drawings

Embodiments will be described, by way of example only, with reference to the drawings, in which
FIG. 1 illustrates, schematically, a silicon bipolar junction transistor (BJT) 100 according to one or more embodiments of the present disclosure;
FIG. 2 illustrates, schematically, a part-processed Si BJT 200 according to one or more embodiments of the present disclosure, alongside other types or devices which may be fabricated alongside the Si BJT in the same technology node or process flow;
FIG. 3 this shows, schematically, the results of this etch process to define the Si BJT according to conventional methods on the left-hand side, and according to embodiments of the present disclosure on the right-hand side;
FIG.s 4 and 5 illustrate, schematically, a part-processed Si BJT according to one or more embodiments of the present disclosure, at successively later stages of processing, again alongside other types or devices which may be fabricated alongside the Si BJT in the same technology;
FIG. 6 this shows, schematically, the results of this etch process (emitter definition or EDF etch) according to conventional methods on the left-hand side, and according to embodiments of the present disclosure on the right-hand side;
FIG.s 7 to 10 illustrate, schematically, a part-processed Si BJT according to one or more embodiments of the present disclosure, at successively later stages of processing, again alongside other types or devices which may be fabricated alongside the Si BJT in the same technology;
FIG. 11 illustrates, schematically, the Si BJT of FIG 1, alongside a low-voltage NPN SiGe HBT, and a high-voltage NPN SiGe HBT, which may have been fabricated alongside the Si BJT in the same technology node or process flow; and
FIG. 12 shows a flow diagram of a process according to one or more embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### Detailed description of embodiments

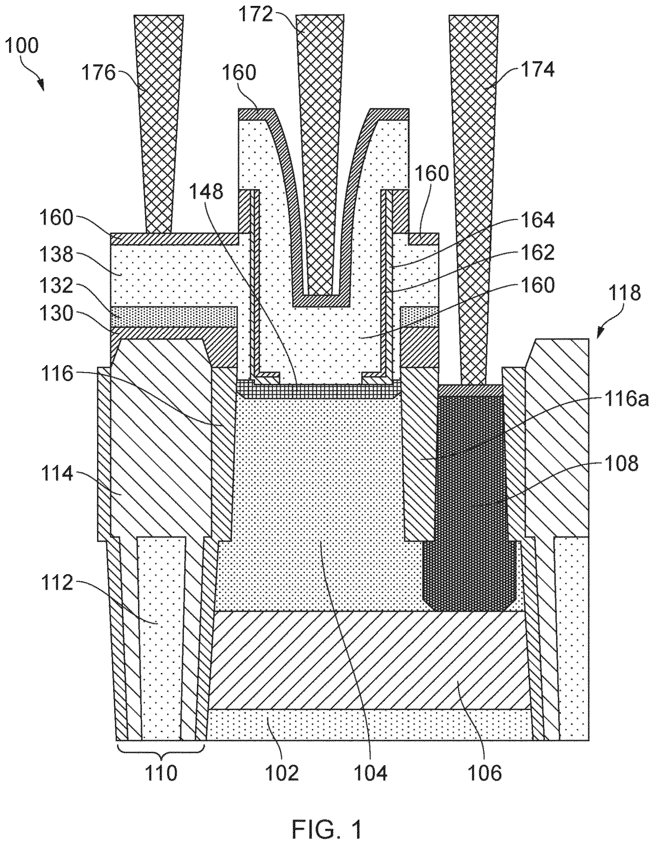

FIG. 1 illustrates, schematically, a silicon bipolar junction transistor (BJT) 100 according to one or more embodiments of the present disclosure. The Si BJT device 100 includes a substrate 102 which may be a doped p-type, on which is grown an epitaxial layer 104 which may be doped n-type. An n-type buried layer ("BN") 106 is provided and forms an n-well. Electrical connection to this buried n-type layer may be provided by a deep n-collector region ("DNC") 108 doped heavily n-type, typically by ion implantation with phosphorus (P), in order to provide a low resistivity electrical path connection to the surface of the device. Isolation for the device may be provided by deep trench isolation ("DTI") 110 comprising polysilicon material 112 formed in a trench which includes an inner lining of a first oxide material 114 and an outer lining of a second oxide material 116. The second oxide material 116 may also at least isolate, as shown at 116a, the deep n-collector region from the (eventual) base region. The first oxide material 114, together with the second oxide material 116 may also provide shallow trench isolation (STI) 118 around the device. The second oxide material providing shallow trench isolation is formed using a LPCVD (low pressure chemical vapour deposition) from TEOS (tetra-ethyl-ortho-silicate), and thus may be referred to as TEOS (or "TEOS oxide"). A heavily doped, shallow, p-type region 148 may be formed by ion implantation at the top of the collector region 104. This region forms the p-type base of the BJT. Over, and in contact with the base region, is a region of n-doped silicon 160 forming the emitter of the BJT. This region is doped n-type; where it is in contact with the p-type base it generally grows epitaxially to provide monocrystalline material - however elsewhere the layer may grow as polycrystalline silicon. Electrical connection is provided to the emitter region of the device by an emitter contact, as shown schematically at 172. Electrical contact is provided to the collector region of the device by a collector contact, shown schematically at 174. Electrical contact is provided to the base region of the device by a base contact, shown schematically at 176.

The emitter region, and in particular the n-doped silicon 160 are electrically isolated from other parts of the device by being within a so-called "emitter window". The emitter window is created by selectively etching layers overlying the active (base and collector) regions of the device. The window is lined with dielectric layers, typically comprising a multi-layer stack, comprising oxide and nitride as illustrated at 164 and 162 respectively. Outside of the window is a polysilicon base ("PSB") layer 138, which provides a low resistivity path between the (intrinsic) base region 148, and the base contact 176. Between the polysilicon base layer 138 and the oxide - particularly the shallow trench isolation oxide 114 and 116, is a layer 130 of a dielectric, which is typically a nitride, on top of which is a layer stack 132 comprising silicon germanium (SiGe). These layers do not contribute to the architecture of the BJT itself, but are formed, during the manufacturing process, as part of the fabrication of SiGe heterojunction bipolar transistors (SiGe HBTs) on the same wafer or product. A layer of a silicide material 166 covers surface of the polysilicon base 138, and the surface of the n-doped silicon emitter 160. Without limitation, the silicide may be nickel silicide, cobalt silicide, or a silicide of an alloy of multiple metals.

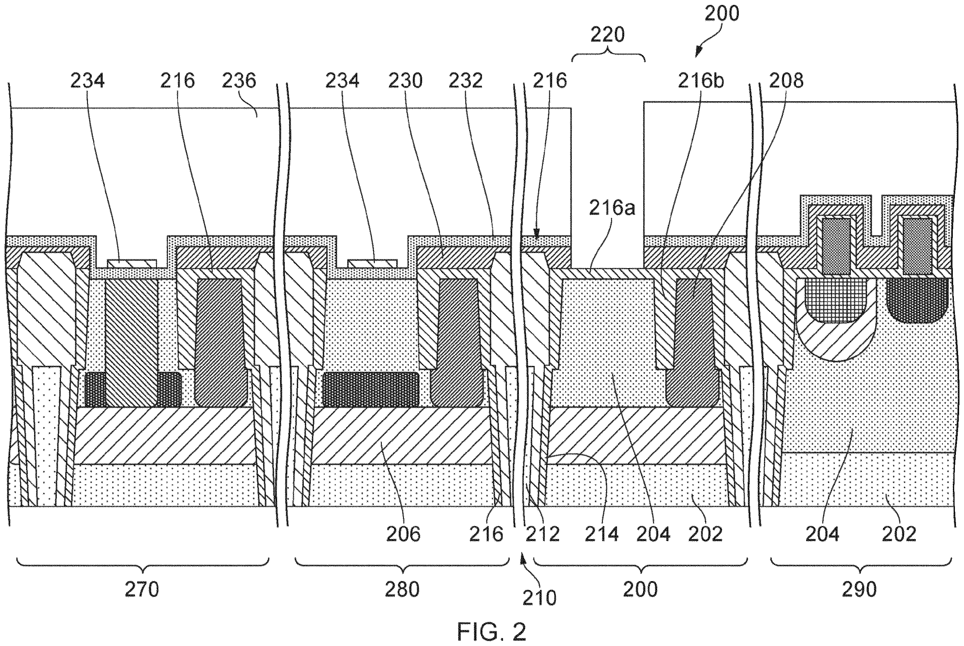

FIG. 2 illustrates, schematically, a part-processed Si BJT 200 according to one or more embodiments of the present disclosure, alongside other types or devices which may be fabricated alongside the Si BJT in the same technology node or process flow. The other devices are shown for illustration purposes only, in order to demonstrate the compatibility of methods according to the present as closure with the fabrication of these devices. As shown in figure 2, these devices may include a low-voltage npn SiGe HBT 270, a high-voltage npn SiGe HBT 280, and logic circuitry or logic device 290.

The Si BJT device 200 includes a substrate 202 which may be a doped p-type, on which is grown an epitaxial layer 204 which may be doped n-type. An n-type buried layer ("BN") 206 is provided and forms an n-well. Electrical connection to this buried n-type layer may be provided by a deep n-collector region ("DNC") 208 in a trench, which may be formed by heavy n-type ion implantation, in order to provide a low resistivity electrical path connection to the surface of the device. Isolation for the device may be provided by DTI 210 comprising polysilicon material 212 formed in a trench which includes an inner lining of a first oxide material 214 and an outer lining of a second oxide material 216. The second oxide material 216 may also isolate, as shown at 216a, the deep-n collector region from the (eventual) base region. The first oxide material 214, together with the second oxide material 216 may also provide STI 218 around the device. The second oxide material providing STI may be TEOS (or "TEOS oxide"). The TEOS layer 216 is deposited across the complete wafer or product, and then patterned, resulting in a liner oxide, using a photolithography stage, in order to remove it from the areas of the wafer product where it is not required. As can be seen in figure 2, in devices such as low-voltage npn SiGe HBT 270 and high-voltage npn SiGe HBT 280 the oxide is removed from an active area, of each device (which will eventually become an emitter window) to expose the n-type epitaxial silicon 204.Typically, in the simultaneously grown logic device 290 the oxide is removed, and then a new oxide layer grown and immediately followed by deposition of polysilicon, resulting in the thin oxide layer visible in the figure.

In conventional Si BJT fabrication processes, the oxide is removed from a central region of the Si BJT device (the central region 220 includes a region which will eventually become the emitter window and active area of the device, but extends beyond it to provide room for an electrical connection to be provided, by a polysilicon base layer, to the eventual intrinsic base of the device. However, as can be seen in FIG. 2, according to embodiments of the present disclosure, the oxide is not removed from this area. The n-doped epitaxial silicon (which forms the collector of the bipolar junction transistor) remains covered by TEOS oxide 216a. TEOS oxide 216 serves several functions during the later device processing, and in particular it acts to protect the surface of the n-doped collected region 204. It may therefore also be referred to as a "protective oxide layer".

Subsequent to formation of the protective oxide layer over the active area of the Si BJT device, typically a dielectric layer 230, which is typically a nitride layer, is deposited across the device. This layer may be patterned in order to remove it from active areas of HBT devices on the same wafer. Subsequent to the deposition of the dielectric layer 230, a layer stack 232 comprising SiGe is deposited, across the wafer.

The dielectric 230 and layer stack 232 comprising SiGe are not required for the Si BJT. However in products in which the Si BJT is fabricated alongside other devices such as SiGe HBT, these layers may be required. For example, in a SiGe HBT, the SiGe forms the base of the heterojunction device. The quality of the interface between the layer stack comprising silicon germanium and the N-type epitaxial silicon layer 204 which forms the collector of the HBT device may be important.

Subsequent to deposition of the layer stack comprising SiGe, another protective oxide 234 ("Emitter Protect, EPR") layer may be deposited, and patterned to leave it over the SiGe in the active region of the HBT devices, in order to protect the SiGe during subsequent processing. Again, it will be appreciated that this process stage is not required for the Si BJT device 200 itself.

As shown in figure 2, a photoresist layer 236 is deposited across the wafer and patterned to expose the layer stack 232 comprising SiGe over at least the active area of the BJT device. The layer stack 232 comprising SiGe and the dielectric 230 are then etched, using an etchant which has selectivity against oxide. The TEOS oxide 216a provides an effective etch stop.

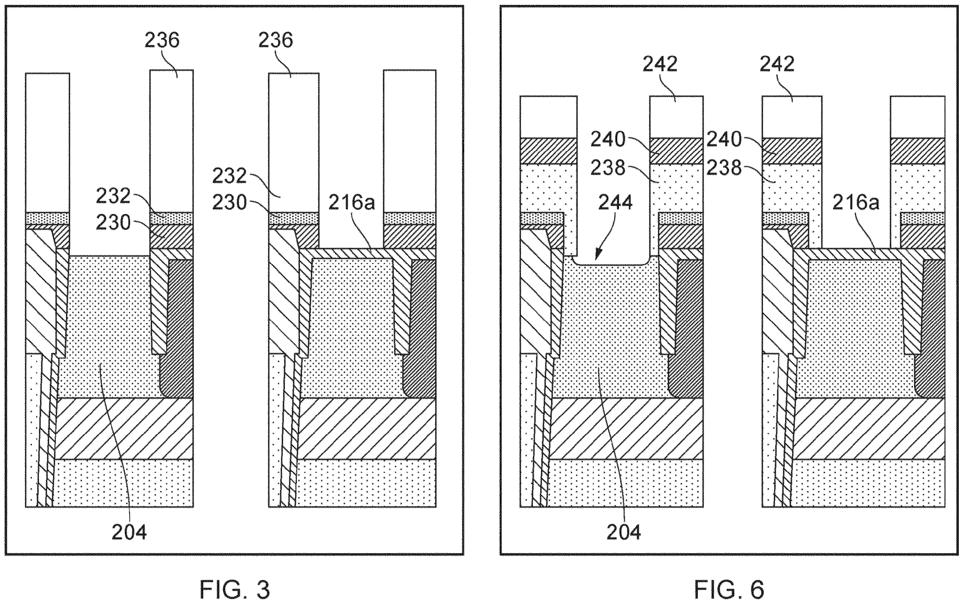

Turning to FIG. 3, this shows, schematically, the results of this etch process according to conventional methods on the left-hand side, and according to embodiments of the present disclosure on the right-hand side. That is to say, the right-hand side is an expanded view of detail of FIG. 2. Because, according to embodiments of the present disclosure, the etch stops on the TEOS oxide 216a, and this oxide layer will subsequently be removed, the process control for the etching of the layer stack comprising SiGe and the dielectric may be significantly relaxed. In particular, it generally will not matter significantly if there is a small amount of over etch and the oxide layer is somewhat thinned. In contrast, the etching of these layers in conventional methods requires stopping at the surface of the epi silicon 204 which will become the base of the BJT. Tight process control may therefore be required according to conventional methods, in order to avoid over etching and/or disrupting the surface of this layer.

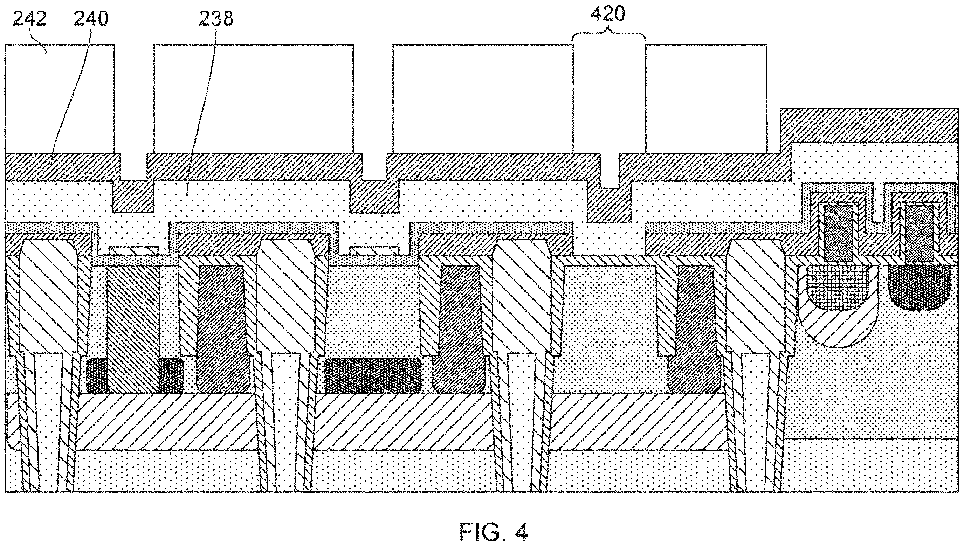

FIG. 4 illustrates, schematically, a part-processed Si BJT according to one or more embodiments of the present disclosure, at a later stage of processing, again alongside other types or devices which may be fabricated alongside the Si BJT in the same technology. A polysilicon layer 238 (also referred to as a "polysilicon base" ("PSB") layer since it provides a path for electrical connection to the intrinsic base of the BJT) is deposited across the wafer, followed by a further dielectric layer 240 which is typically a nitride. The skilled person will be familiar with the terminology polysilicon base used to define the low resistivity path for providing electrical connection to the intrinsic base. This is followed by a further photolithography stage (emitter definition "EDF") defining a patterned photoresist layer 242 with emitter window 420 openings therein which expose the further dielectric layer 240 in active of the BJT (and also in the active areas of the HBTs).

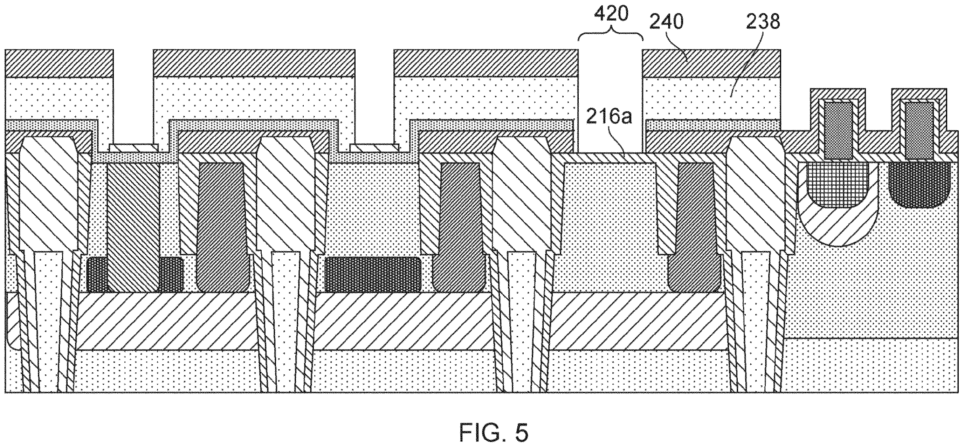

FIG. 5 illustrates, schematically, a part-processed Si BJT according to one or more embodiments of the present disclosure, at a later stage of processing, again alongside other types or devices which may be fabricated alongside the Si BJT in the same technology. The patterned emitter definition photoresist layer has been used to mask parts of the devices during etching through the further dielectric layer or nitride 240 and the PSB layer. The protective oxide layer 216a provides an etch stop for the PSB etch for the BJT device. It will be noticed that, at the same time, the further oxide layer 234 protecting the SiGe base layer of the HBT devices provides an etch stop for the PSB etch.

Turning to FIG. 6, this shows, schematically, the results of this etch process (emitter definition or EDF etch) according to conventional methods on the left-hand side, and according to embodiments of the present disclosure on the right-hand side. That is to say the right-hand side is an expanded view of detail of FIG.5. As can be seen on the right-hand side of the figure, the etchant for the PSB layer 238 stops on the TEOS 216a. Similar to the etching shown in figure 3, a process control for this etch process may be relatively relaxed relative to that for a conventional process which is shown on the left-hand side of the figure. In particular, in the conventional process the etching stops on the silicon the collector layer 204. That is to say, a polysilicon layer is etched, and it is necessary to stop the etch once the underlying silicon is reached. It is important that all of the polysilicon is removed, and thus, in order to accommodate process variation across the wafer and process tolerances, the surface of the silicon collector layer 204 will generally be slightly etched, resulting in an etched surface 244 of the epi silicon, which is recessed at least to some extent. Since several of the device parameters are affected by the precise positioning of the surface, (particularly close to the edge of the emitter window) such an over etch is undesirable. Embodiments of the present disclosure may eliminate the over etching.

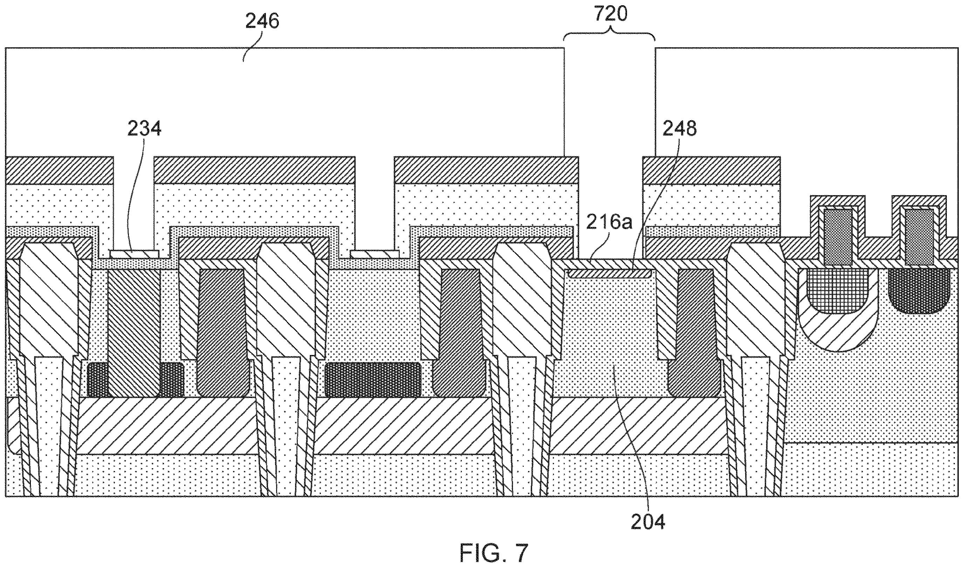

FIG. 7 illustrates, schematically, a part-processed Si BJT according to one or more embodiments of the present disclosure, at a later stage of processing, again alongside other types or devices which may be fabricated alongside the Si BJT in the same technology. A further photoresist layer 246 is applied across the wafer and patterned at 720 to expose the emitter window of the BJT device. Note that the resist is not patterned over other devices on the wafer, and the opening 720 in the further photoresist layer is wider than the emitter window, and typically similar sized to the central region opening 220. An ion implementation step is then performed to form a shallow heavily p-doped base region in the silicon epi 204. The ion implantation may typically be carried out using boron (B) as the dopant. The base thickness is generally small, typically being in a range between 50 and 100nm or even between 25 and 50 nm, for which a shallow implantation is required. However, the base doping is generally required to be high, and is typically of the order of 5E18 to 1 E20 /cm³.

In conventional processes, this implantation is carried out directly onto the epitaxial silicon 204. As a result, in conventional processing, this may become contaminated during the iron implantation process. Moreover, there is a potential of non-uniform implantation resulting from implant channelling. The skilled person will be aware that this is a phenomenon which relates to ions having a non-uniform penetration depth depending on the angle of implant, as they are effectively channelled between atoms in the silicon crystal lattice. However, according to embodiments of the present disclosure, the risk of implant channelling may be reduced or even eliminated due to the presence of the TEOS layer, which acts as a screening layer: since the oxide does not have a well-defined crystal lattice it interrupts or deflects ions, thereby randomising their direction.

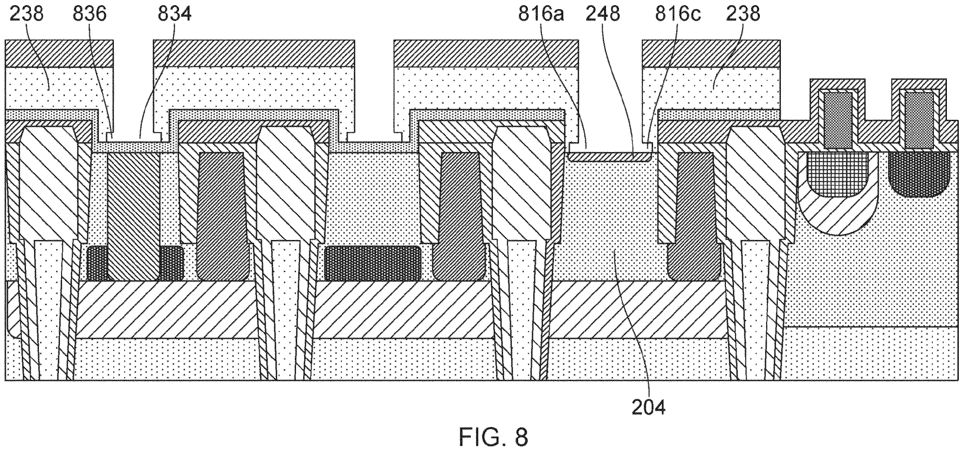

FIG. 8 illustrates, schematically, a part-processed Si BJT according to one or more embodiments of the present disclosure, at a later stage of processing, again alongside other types or devices which may be fabricated alongside the Si BJT in the same technology. Subsequent to the ion implantation shown in FIG. 7, and stripping of the further photoresist layer 246, the protective oxide layer is etched (typically by wet oxide etch. In a conventional process, this results in removal of the emitter protect oxide 234 on the associated HBT devices but has no effect on the BJT device. However, according to embodiments of the present disclosure, the oxide wet etch also removes the TEOS oxide layer 216a which overlies the silicon epi 204 (and is now immediately above the implanted p-doped base layer 248), as shown by empty space 816a. It will be appreciated that the wet oxide etch is generally isotropic, and not only removes the exposed oxide, but also undercuts the polysilicon base layer. This results in voids or cavities forming between the polysilicon base layer and the p-type base. These cavities are shown at 816c. Corresponding cavities are formed in the HBT devices as shown at 836, where the removal of the protective oxide results in empty space 834 extending underneath the polysilicon base layer 238. The cavity or voids may be the thickness of the TEOS, that is to say typically in a range between 10 and 25 nm, or in a range between 5 nm and 10 nm. The width may generally be the overlay tolerance - that is to say the potential misalignment between two lithography stages - of the lithography used. Thus, the width may typically be in a range of 25 to 100 nm or in a range of 15 to 50 nm.

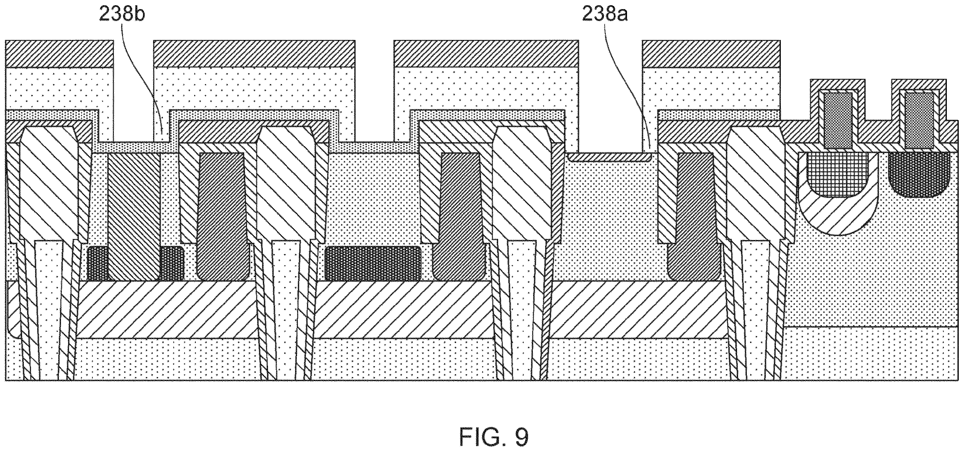

FIG. 9 illustrates, schematically, a part-processed Si BJT according to one or more embodiments of the present disclosure, at a later stage of processing, again alongside other types or devices which may be fabricated alongside the Si BJT in the same technology. This figure shows the device after the cavities of voids have been filled or sealed. The sealing may be achieved by a thermal process, for example an exposure to a temperature within a range of 800°C to 850°C for a few minutes (such as less than 10 minutes). In particular, by heating the device, the polysilicon material in polysilicon base layer 238 may flow or migrate into the void, thereby filling the void with reflowed silicon material 238a and sealing the cavity. (It will be appreciated that in the ideal case, the cavity is completely filled; however, depending on the exact flow of the silicon atoms it may be that the void is not entirely filled but leaves one or more microcavities, typically less than 25% of the original extent of the cavity, and typically <20nm across. It will be noted that the cavities only exist due to the etching of the protective oxide layer, and in conventional or processes no such cavities exist in the BJT device (since conventional processes typically do not involve a protective oxide during this process stage). It will further be appreciated by comparison with the HBT devices also shown in figure 9, that this sealing is required by the HBT, as shown by the reflowed silicon material 238b, irrespective of its use for the BJT, and so it is not an additional process step. In other words, processes according to embodiments of the present disclosure do not involve an additional process step compared to conventional processing at this stage of the fabrication of wafers or products incorporating both BJT and HBT devices.

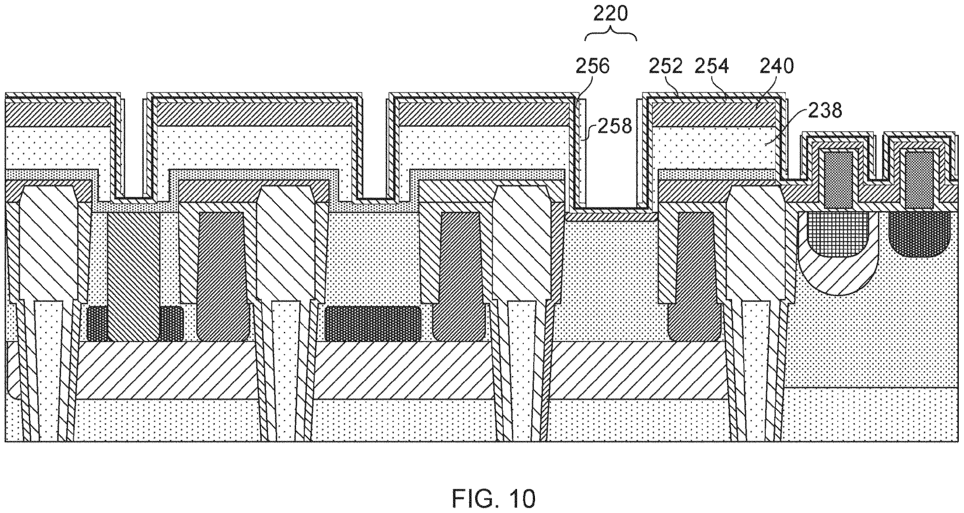

FIG. 10 illustrates, schematically, a part-processed Si BJT according to one or more embodiments of the present disclosure, at a later stage of processing, again alongside other types or devices which may be fabricated alongside the Si BJT in the same technology. Subsequent to the cavity sealing illustrated in figure 9, further dielectric layers are deposited across the device. These may, as shown, comprise an oxide-nitride-oxide (ONO) stack comprising a nitride layer 252 between two oxide layers 254 and 256, although the skilled person will be familiar that other combination of layers may alternatively be used. Spacers 258 are then formed onto the sidewall of the emitter window, as shown. This may be carried out, for example, by depositing a polysilicon layer across the device and then etching it using an anisotropic etch such as a dry etch process to leave spacers on the sidewall of the emitter window. Subsequently to the stage shown in FIG. 10, the nitride of the ONO is etched after a short breakthrough step that removes the thin top oxide of the ONO stack. In the process of etching the nitride of the ONO stack also the polysilicon is removed. Then removing the remaining oxide in between the L-shaped spacers, also removes the oxide that was below the polysilicon on the sidewalls. Hence, we have created L-shaped nitride spacers with a thin oxide below.

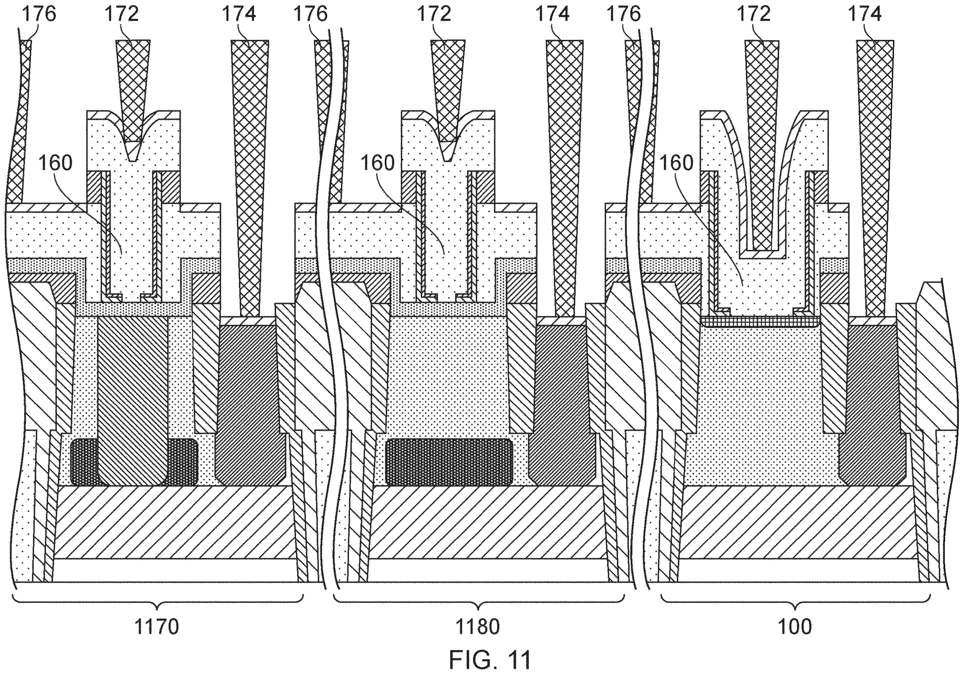

FIG. 11 illustrates, schematically, the Si BJT 100 of FIG 1, alongside a low-voltage NPN SiGe HBT 1170, and a high-voltage NPN SiGe HBT 1180, which may have been fabricated together with the Si BJT in the same technology node or process flow. Device processing has been completed by providing the n-doped silicon 160 forming the emitters of the BJT and HBTs, along with the electrical connections to the respective emitter, collector and base regions of the respective devices, as shown schematically at 172, 174 and 176.

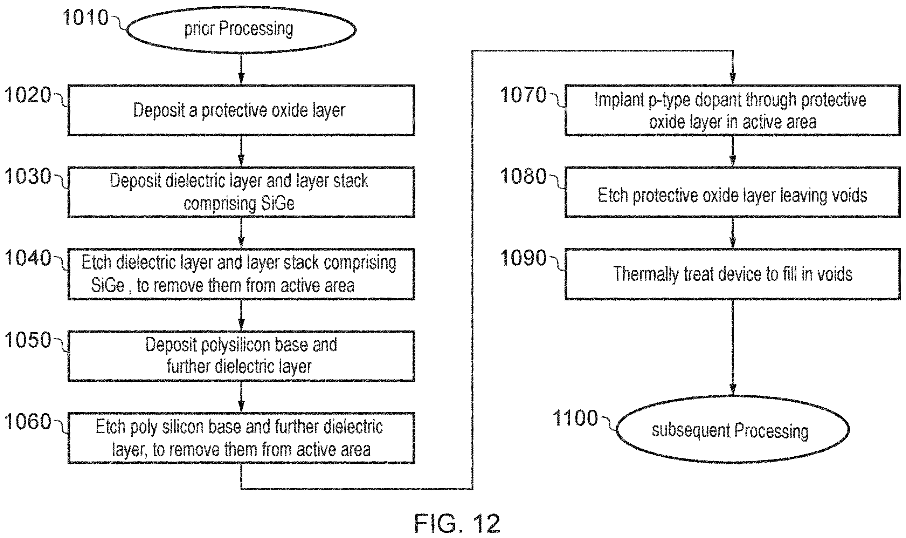

FIG. 12 shows a flow diagram of a process according to one or more embodiments of the present disclosure. After prior processing steps at 1010, a protective oxide layer is deposited at step 1020. At step 1030, a dielectric layer and a layer stack comprising silicon germanium are deposited. At step 1040, the dielectric layer and the layer stack comprising silicon germanium are etched, to remove them from an active area of the BJT. At step 1050, a poly silicon base layer and a further dielectric layer are deposited. At step 1060, the poly silicon base and the further dielectric layer are etched, to remove them from an active area of the device. At step 1070, a P-type dopant is implanted through the protective oxide layer in the active area of the device. This creates an implanted region which will form the base of the BJT. At step 1080 the protective oxide layer is etched, which results in voids remaining between the poly silicon base layer and the implanted region. At step 1090, the device is thermally treated, typically by exposure to a temperature in a range of 800° C and 850° C for a few minutes such as less than 10 minutes, in order to fill-in or to seal the voids. Thereafter are subsequent processing steps, as shown at 1100.

From reading the present disclosure, other variations and modifications will be apparent to the skilled person. Such variations and modifications may involve equivalent and other features which are already known in the art of semiconductor fabrication, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims [delete if not relevant] and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

### LIST OF REFERENCE SIGNS

- 100: Si Bipolar Junction Transistor
- 102: substrate
- 104: epitaxial layer
- 106: buried n-type layer
- 108: deep n-collector region
- 110: deep trench isolation
- 112: polysilicon material
- 114: first oxide material
- 116: second oxide material
- 118: shallow trench isolation
- 130: dielectric layer
- 132: layer stack comprising SiGe
- 138: polysilicon layer
- 148: p-type base region
- 160: n-doped silicon emitter
- 162: nitride
- 164: oxide
- 166: silicide material
- 172: emitter contact
- 174: collector contact
- 176: base contact
- 200: Si Bipolar Junction Transistor
- 202: substrate
- 204: epitaxial layer
- 206: buried n-type layer
- 208: deep n-collector region
- 210: deep trench isolation
- 212: polysilicon material
- 214: first oxide material
- 216: second oxide material
- 216a: TEOS oxide
- 216b: second oxide
- 218: shallow trench isolation
- 220: central region
- 230: protective dielectric layer
- 232: layer stack comprising SiGe
- 234: protective oxide/emitter protect
- 236: photoresist
- 238: polysilicon layer (/"PSB")
- 238a, 238b: reflowed silicon material
- 240: further dielectric layer
- 242: photoresist
- 244: etch surface of epi silicon
- 246: further photoresist layer
- 252: nitride layer
- 254, 256: oxide layer
- 258: spacers
- 270: low-voltage SiGe HBT
- 280: high-voltage SiGe HBT
- 290: logic device
- 420: emitter window
- 720: opening in further photoresist layer
- 816a: empty space
- 816c: cavities or voids
- 834: empty space in HBT
- 836: cavities or voids in HBT
- 1170: low-voltage SiGe HBT
- 1180: high-voltage SiGe HBT

## Claims

1. A method of manufacturing a Si bipolar junction transistor, BJT, device (200), the method comprising:
prior processing steps (1010);
deposition (1020) of a protective oxide layer (216a) at over least an active area of the Si BJT device;
deposition (1030) of a dielectric layer (230), and a layer stack (232) comprising SiGe, on the protective oxide;
etching (1040) the dielectric layer, and the layer stack comprising SiGe, thereby removing them from the active area of the Si BJT;
deposition (1050) of a polysilicon layer (238), and a further dielectric layer (240), across the device;
etching (1060) the polysilicon layer, and the further dielectric layer thereby removing it from the active area of the Si BJT;
implanting (1070), through the protective oxide layer, a p-type dopant into the active area of the Si BJT;
etching (1080) the protective oxide layer, thereby removing it, and leaving voids under the dielectric layer;
thermally treating (1090) the Si BJT device, thereby filling in voids under the dielectric layer with material from the polysilicon layer; and
subsequent processing steps (1100).

2. The method of claim 1, wherein the protective oxide layer is formed from TEOS.

3. The method of claim 1 or 2, wherein the dielectric layer comprises a nitride material.

4. The method of any preceding claim, wherein the further dielectric layer comprises a nitride material.

5. The method of claim any of claims 1 to 3, wherein the p-type dopant is boron.

6. The method of any preceding claim, wherein the protective oxide layer has a thickness within a range of 25 nm to 150 nm.

7. The method of any preceding claim, wherein the step of thermally treating the Si BJT device comprises heating it to a temperature such that at least one of atoms and ions of the polysilicon layer migrate into the voids, thereby reducing the size of the voids by at least 75%, within a time which is no more than 10 minutes.

8. The method of any preceding claim, wherein the protective oxide layer extends beyond the active area of the Si BJT device.

9. The method of any preceding claim, further comprising fabricating a SiGe HBT in a same process flow.

10. A Si bipolar junction transistor, BJT, device (200), comprising
An n-type collector region (204) grown epitaxially on a silicon substrate;
an implanted p-type base region (248) formed in a top region of the collector region;
a dielectric layer (130), and a layer stack comprising SiGe (132), formed non-adjacent to an emitter window (520) and on a part of the base region;
a polysilicon layer (138), over the dielectric layer, between the dielectric layer and the emitter window and between the layer stack comprising SiGe and the emitter window, the polysilicon layer for providing electrical contact to the base region;
dielectric material (162, 164) lining and thereby defining the emitter window;
further silicon material (160) within the emitter window and providing an n-emitter base region, and for providing electrical contact to the n-type emitter region;
wherein the polysilicon layer comprises non-uniformities (238a) adjacent at least a lower part of the dielectric layer (130).

11. The Si BJT as claimed in claim 10, wherein the non-uniformities comprise micro-voids.

12. The Si BJT as claimed in claim 10 or 11, wherein the non-uniformities comprise silicon material having a different doping level than a remainder of the polysilicon layer.

13. The Si BJT as claimed in any of claims 10 to 12, wherein the polysilicon layer adjacent the implanted p-type base region is not epitaxial therewith.

14. The Si BJT as claimed in any of claims 10 to 13, wherein an upper surface of the implanted p-type base region has a uniform height.

15. A semiconductor product comprising a Si BJT as claimed in any of claims 10 to 14, and a SiGe heterojunction bipolar transistor, HBT.
